# EUROPEAN PATENT APPLICATION

(11) **EP 3 772 820 A1**
(43) Date of publication of application: **10.02.2021**
(21) Application number: 19190431.7
(22) Date of filing: 07.08.2019
(51) Int. Cl.: H03F 3/195, H03F 1/34, H03F 1/14, H03F 1/56

(54) **TRANSISTOR CIRCUITS AND METHODS FOR SOURCE DEGENERATION**

(71) Applicant: Infineon Technologies AG, 85579 Neubiberg (DE)
(72) Inventor: Seebacher, David, 9500 Villach (AT); Bassi, Matteo, 9500 Villach (AT); Padovan, Fabio, 9500 Villach (AT)
(74) Representative: Sticht, Andreas

(57) **Abstract**

Transistor circuits are provided including a transistor (13), a first inductor (11) coupled to the gate terminal of the transistor (13) and a second inductor (12) coupled to the drain terminal of the transistor. The first and second inductors (11, 12) are inductively coupled to provide a source degeneration effect.

## Description

### TECHNICAL FIELD

The present application relates to transistor circuits and to related methods.

### BACKGROUND

Transistors are used in many electronic devices for example to switch, control or amplify voltages or currents. A frequently used transistor type is a field effect transistor like a MOSFET (metal-oxide semiconductor field effect transistor), where essentially a resistance between source and drain terminals is controlled by a gate-source voltage of the field effect transistor. Such transistors may be based on various semiconductor materials including silicon (Si), silicon carbide (SiC), gallium arsenide (GaAs) or gallium nitride (GaN).

In radio frequency (RF) applications, such field effect transistors are used for example to implement amplifiers like low noise amplifiers (LNAs). In such RF applications, so-called source degeneration is a common approach to control the gain of the transistor or amplifier, to improve stability and/or to provide input matching and/or improve linearity. In conventional source degeneration, an element is coupled to a source terminal of a field effect transistor. In RF applications, this element is usually an inductor, whereas for low frequency applications also resistors may be used.

This conventional source degeneration requires a floating source. However, a floating source may be undesirable in some applications or may not be available in some technologies. Moreover, sometimes it may be difficult to define and select such an inductor coupled to the source accurately, for example in cases where an inductance of a package of the device is part of the source degeneration, or when a single-ended circuit implementation is used where a ground return path of circuitry including the element coupled to the source terminal may be difficult to avoid, respectively design to a required value.

### SUMMARY

A transistor circuit as defined in claim 1 and a method for manufacturing a transistor device as defined in claim 14 are provided. The dependent claims define further embodiments.

According to an embodiment, a transistor circuit is provided, comprising:
a transistor,
a first inductor coupled to a gate terminal of the field effect transistor, and
a second inductor coupled to a drain terminal of the field effect transistor, wherein the first inductor and the second inductor are inductively coupled to provide a source degeneration effect for the field effect transistor.

According to another embodiment, a method for operating a transistor circuit is provided, comprising:
operating a transistor, and
using a first inductor coupled to a gate terminal of the field effect transistor and a second inductor coupled to a drain terminal of the field effect transistor to provide a source degeneration effect for the field effect transistor.

The above summary is merely intended to give a brief overview over some embodiments and is not to be construed as limiting, as other embodiments may include other features than the ones discussed above.

### BRIEF DESCRIPTION OF THE DRAWINGS

Fig. 1 is a circuit diagram of a transistor circuit according to an embodiment.
Fig. 2 is a circuit diagram of a transistor circuit according to a further embodiment.
Figs. 3A and 3B are explanatory diagrams of transistor circuits for illustrating how embodiments effect source degeneration.
Figs. 4 to 12 are circuit diagrams of transistor circuits according to further embodiments.
Fig. 13 is a flow chart illustrating a method according to some embodiments.
Fig. 14 is a flow chart illustrating a method according to some further embodiments.

### DETAILED DESCRIPTION

In the following, various embodiments will be described in detail referring to the attached drawings. These embodiments serve only illustrative purposes and are not to be construed as limiting. For example, while embodiments may be described as including a plurality of components, in other embodiments some of these components may be omitted and/or may be replaced by alternative components. In addition to the components explicitly shown and described, additional components may be provided, for example components conventionally used in transistor circuits or radio frequency (RF) circuits.

Features or components from various embodiments may be combined to form further components. For example, in various embodiments various modifications or variations to other embodiments may be described separately. However, such modifications or variations from different embodiments and figures may also be combined unless noted otherwise.

Connections or couplings, unless noted otherwise, apart from couplings between inductors refer to electrical connections or couplings herein. A coupling between inductors as used herein refers to an inductive (magnetic) coupling unless noted otherwise. Such connections or couplings may be modified as long as the general purpose of the connection or coupling, for example to transmit a signal, a voltage and/or a current, or to provide a coupling, is essentially maintained.

Embodiments herein use transistors, in particular field effect transistors like MOSFETs. Such transistors have source, drain and gate terminals. While field effect transistors are used as examples in the following, techniques discussed herein may be applied to various types of transistors, including various type of field effect transistors like MOSFETs (metal oxide semiconductor field effect transistors), JFETs (junction field effect transistors) or HEMTs (high electron mobility transistors), but also other transistors like BJTs (bipolar junction transistors) or IGBTs (insulated gate bipolar transistors). As used herein, the term "gate" also includes the base of transistors like BJTs, the term "source" also includes the emitter of transistors like BJTs and IGBTs, and the term "drain" also includes the collector of transistors like BJTs and IGBTs. For example, the term "source degeneration" also includes an "emitter degeneration" for transistors having an emitter terminal.

Transistors as used herein may be based on various semiconductor materials, for example group IV materials like silicon, group IV compounds like silicon carbide (SiC), or III-V compounds like gallium arsenide (GaAS)or gallium nitride (GaN).

Some embodiments may be used in radio frequency (RF) applications. Radio frequency may refer to frequencies above 100 kHz, for example in the Megahertz or even Gigahertz range. For example, in some communication applications radio frequency may refer to signals having a frequency of above 1 GHz or above 10GHz.

In some embodiments, a source degeneration effect is achieved without providing an inductor or resistor to a source terminal of a transistor. In this respect, unless noted otherwise, inductors, resistors and other elements refer to elements specifically provided to generate an inductance, a resistance etc. which is above the inductance or resistance generated by usual electrical connections like wires or leads. In other words, simple electrical connections (which always have some amount of resistance and inductance) are not regarded as inductors or resistances in this context. For example, inductors used herein may have an inductance of at least 50 pH (Picohenry), for example more than 100pH or more than 200pH. A source degeneration effect in the sense herein is an effect which causes the transistor to behave similar to a conventional source degeneration, for example as with an inductor in the above sense coupled to the source terminal, or according to a "negative" source degeneration explained further below where the transistor behaves as if a negative inductance were coupled to its source terminal.

In the Figures, in order to avoid repetitions, like elements are designated with the same reference numerals and will not be described repeatedly. Instead, reference will be made to the description of previous figures.

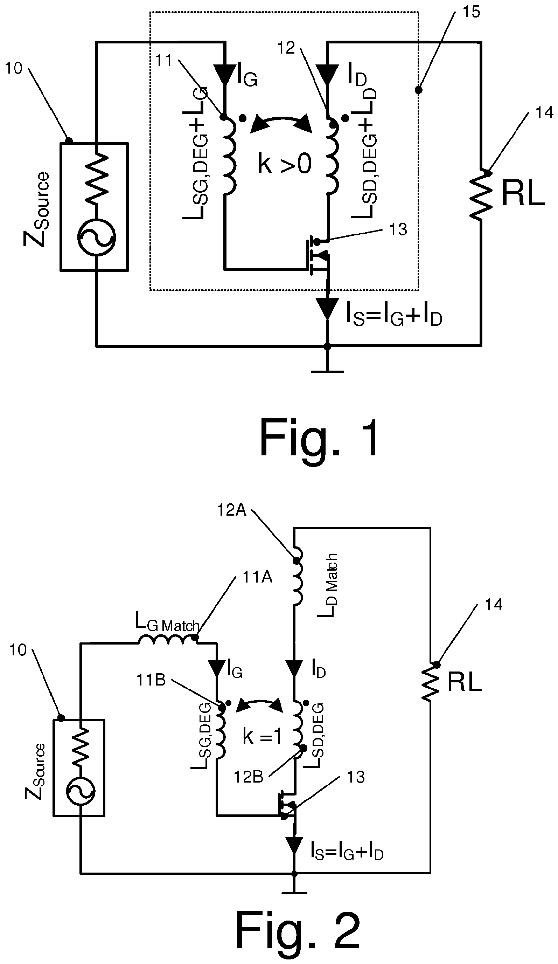

Fig. 1 is a circuit diagram illustrating a transistor circuit according to an embodiment. The transistor circuit of Fig. 1 comprises a field effect transistor 13, having a source terminal, a drain terminal and a gate terminal. Transistor 13 may for example be used in a radio frequency circuit like a low noise amplifier (LNA), but is not limited thereto. In some embodiments, field effect transistor 13 may be a MOSFET transistor. In some radio frequency applications, transistor 13 may be based on a wide bandgap semiconductor material like gallium nitride. In other embodiments, other semiconductor materials like silicon may be used.

Transistor 13 is controlled by a voltage source 10 having an impedance ZSOURCE and being coupled between the gate and source terminals of transistor 13 and therefore applying a gate-source voltage. Using the gate-source voltage, essentially a drain-source resistance and current of transistor 13 may be controlled. In some embodiments, also an operating point of transistor 13 may be set by DC biasing. The voltage generated by voltage source 10 may for example represent an RF signal to be amplified by a low noise amplifier.

A gate inductor 11 is coupled to the gate terminal of transistor 13 between voltage source 10 and transistor 13. Moreover, a drain inductor 12 is coupled to the drain terminal of transistor 13. A dot at the inductors 11, 12 represents the winding direction. In the embodiment of Fig. 1, inductors 11, 12 have the same winding direction and are arranged essentially parallel to each other, resulting in a positive coupling k>0.

Furthermore, transistor 13 has a load 14 coupled between its drain and source terminals. The coupling of load 14 is merely an example, and various loads may be coupled in various manners to transistor 13.

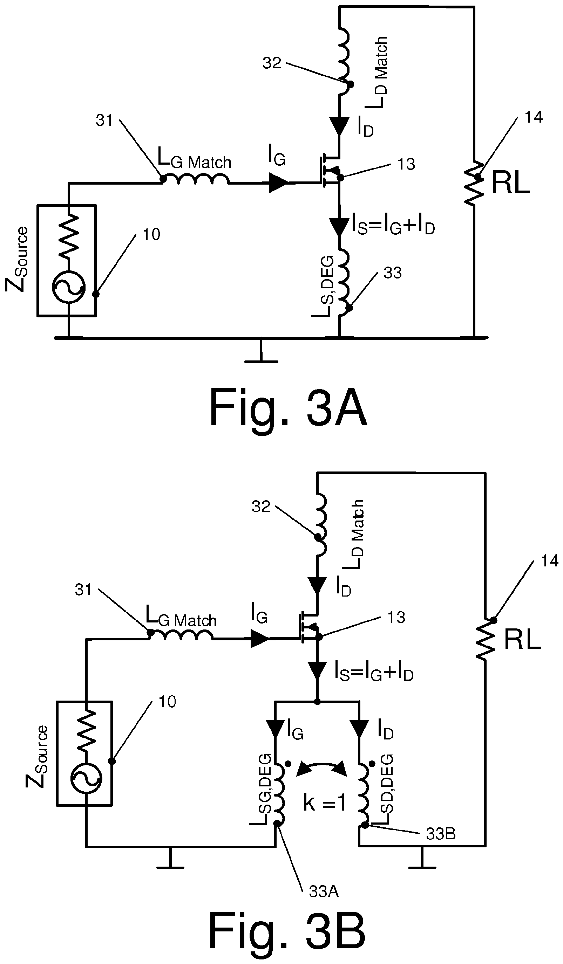

It should be noted that in the embodiment of Fig. 1, no inductor or relevant parasitic inductance is present between the source terminal of transistor 13 and ground. For example, the source terminal of transistor 13 may be coupled to ground by a simple electrical connection like a lead or a wire. Nevertheless, as will be explained further below with reference to Figs. 2, 3A and 3B in more details, inductors 11 and 12 and the coupling therebetween provide a source degeneration effect, i.e. transistor 13 essentially behaves as if a source degeneration inductor were connected between its source terminal and ground. However, in the embodiment of Fig. 1, in contrast to conventional source degeneration, no floating source terminal and no specific source inductor is required.

Inductance values of inductors 11, 12 may be selected to serve two purposes. In Fig. 1, the inductance of gate inductor 11 is represented as a sum of a component inductance L_{SD, DEG} which serves for the coupling to drain inductor 12 for source degeneration and a component L_{G} which serves for gate side (input side) impedance matching. Likewise, an inductance of inductor 12 is represented as a sum of a component L_{SD, DEG} for source degeneration and a component L_{D} for drain side (output side) impedance matching. In this way, in some embodiments inductors 11, 12 may serve both for impedance matching and for providing a source degeneration effect. In some conventional solutions, as mentioned above, a source inductor is used for providing source degeneration, but nevertheless inductors have to be connected to gate and drain terminals for impedance matching.

Due to the same winding direction, as mentioned, the coupling constant k is greater than 0. In some implementations, inductor 11 may have an inductance greater than 100 pH, for example greater than 200 pH or 300 pH. Drain inductor 12 may also have an inductance greater than 100 pH, for example greater than 200 pH or 300 pH. Coupling constant k may be at least 0.1, for example 0.2 or more, for example between 0.3 and 0.5, and may approach a coupling constant k=1.

To provide a high coupling constant, inductors 11 and 12 together with transistor 13 may be integrated on a same chip, which chip is indicated by reference numeral 15 in Fig. 1. Further components may also be provided on this chip. By an integration on the same chip, inductors 11, 12 may be provided close to each other, which enables the provision of high coupling constants. For example, for integration on a chip, inductors may be formed in one or more metal layers on the chip.

In Fig. 1, I_{G} denotes a gate current and I_{D} denotes a drain current. A source current I_{S} is the sum of gate current I_{G} and drain current I_{D}. Voltage source 10, load 14 and the source terminal of transistor 13 are coupled to a common ground, and no floating source terminal is necessary.

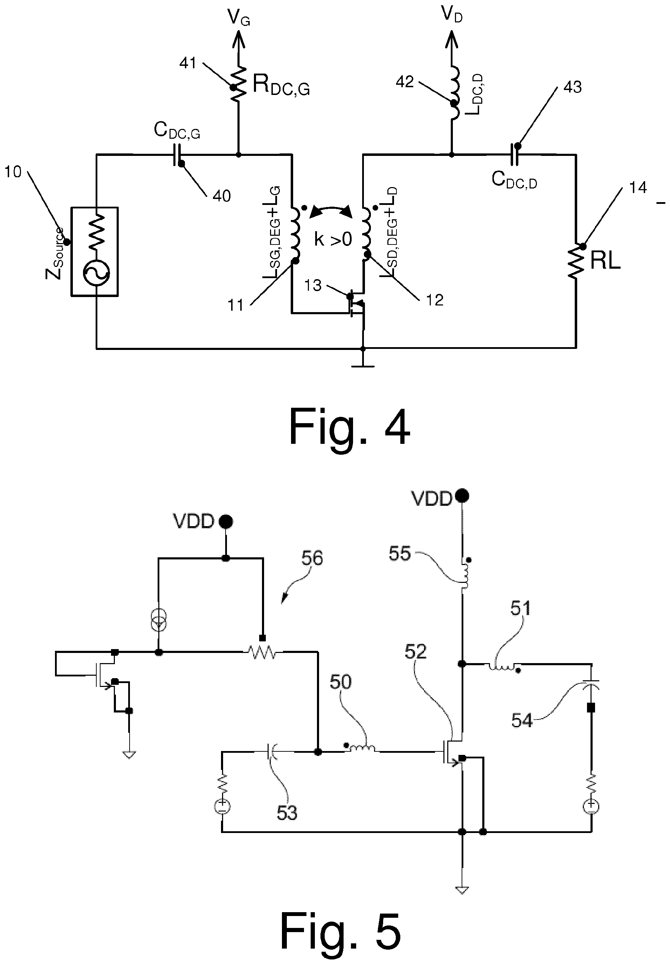

In Fig. 1, additionally a DC biasing on gate and drain side of transistor 13 may be provided, which will be explained later with respect to Fig. 4, but is omitted in Figs. 1 and 2.

While in Fig. 1 inductors for impedance matching and for providing the coupling to provide a source degeneration effect are combined in inductors 11, 12, in other embodiments separate inductors may be provided. Such an embodiment is illustrated in Fig. 2. In Fig. 2, inductor 11 is split into a first inductor 11A having an inductivity L_{G Match} for gate side impedance matching and an inductor 11B having an inductivity L_{SG, DEG} for providing the source degeneration effect. Inductor 12 of Fig. 1 is replaced by a first inductor 12A having an inductivity L_{D Match} for drain side impedance matching and an inductor 12B having an inductivity L_{SD, DEG} for providing the source degeneration effect. Inductors 11A, 12A are merely an example for impedance matching circuitry, and other circuitry conventionally used for impedance matching may also be employed. Similar to inductors 11, 12 of Fig. 1, inductors 11B, 12B are arranged and dimensioned to have a positive coupling constant k to provide the source degeneration effect, for example a coupling constant as mentioned above with respect to Fig. 1. In an ideal case, the coupling constant k may approach or be equal to 1, as shown in Fig. 2.

This ideal case of k=1 will now be used to explain how by providing gate and drain inductors with an appropriate coupling a source degeneration effect may be achieved. For this explanation, reference is additionally made to Figs. 3A and 3B.

Fig. 3A illustrates a conventional transistor circuit with source degeneration. As in Fig. 1 and 2, the device of Fig. 3A comprises voltage source 10, transistor 13 and load 14. A gate inductor 31 is coupled to the gate terminal of transistor 13 having an inductance value L_{Gmatch} for gate side impedance matching, and a drain inductor 32 is coupled to the drain terminal of transistor 13 having an inductance L_{Dmatch} for drain side impedance matching.

Furthermore, the transistor circuit of Fig. 3A comprises a source inductor L_{S, DEG}, which provides source degeneration. To provide source degeneration, the source terminal of transistor 13 may be floating.

Fig. 3B illustrates a modification of the transistor circuit of Fig. 3A. Here, source inductor 33 is replaced by two perfectly coupled (k=1) source degeneration inductors 33A, 33B. Inductor 33A is provided in a "loop" between source and gate terminals of transistor 13, together with voltage source 10 and gate inductor 31, and inductor 33B is coupled in a "loop" between source and drain terminals of transistor 13 together with load 14 and inductor 32. This separation or source inductor 33 into inductors 33A and 33B separates the source current I_{S} in Fig. 3A into the gate current (I_{G}) flowing through inductor 33A and the drain current I_{D} flowing through inductor 33.

These inductors 33A, 33B may then be "moved" to a different position in the respective "loop", namely towards the gate terminal of transistor 13 in case of inductor 33A and towards the drain terminal of transistor 13 in case of inductor 33B, to thus arrive at the embodiment shown in Fig. 2. Based on this, it can be easily understood that by providing inductively coupled gate and drain inductors as in Figs. 1 and 2, a source degeneration effect similar to the effect provided by inductor 33 of Fig. 3A may be obtained.

Fig. 4 illustrates a transistor circuit according to a further embodiment. The transistor circuit of Fig. 4 is based on the transistor circuit of Fig. 1. Similar modifications as now described for Fig. 4 with respect to Fig. 1 may also be provided to other embodiments, for example the embodiment of Fig. 2.

In particular, in the embodiment of Fig. 4, DC biasing using a DC gate voltage V_{G} and a DC drain voltage V_{D} is used. Voltage V_{G} is provided to gate inductor 11 via a resistor 41, and voltage V_{D} is provided to drain inductor 12 via an inductor 42. Resistor 41 may have a resistance value R_{DC, G} of between 50kOhm and 200kOhm, for example about 100kOhm, and inductor 42 may have an inductance value L_{D, D} of between 5nH and 20nH, for example about 10nH. However, these values are merely examples, and other values may be used depending on the implementation. Furthermore, DC decoupling capacitors 40 on the gate side and 43 on the drain side are provided to decouple DC voltages V_{G} and V_{D} from some circuit parts. Capacitor 40 is provided between voltage source 10 and resistor 41 as shown, and capacitor 43 is provided between inductor 42 and load 14, as shown in Fig. 4. A transistor circuit as shown in Fig. 4 may for example be used in low noise amplifier.

A circuit based on the transistor circuit of Fig. 4 has been simulated and compared with a conventional device. Fig. 5 illustrates the circuit schematic used for simulation. Transistor 52 in Fig. 5 corresponds to transistor 13, inductor 50 corresponds to inductor 11, inductor 51 corresponds to inductor 12. Capacitors 53, 54 correspond to capacitors 40, 43 of Fig. 4, respectively. Drain side DC biasing is done via an inductor 55 corresponding to inductor 42, and gate side biasing is done via a circuit part 56, which includes circuitry comprising a current source and a diode-connected transistor to generate DC gate voltage V_{G}. For comparison, a similar circuit based on the conventional source degeneration using a source inductor as shown in Fig. 3 has been simulated.

For the simulation of the circuit of Fig. 5, inductor 50 had an inductance of 500 pH and inductor 51 had an inductance of 400 pH. A coupling constant k between inductors 50 and 51 was 0.35. In the simulation based on Fig. 3, a source inductor of 250 pH was used.

The simulation was done for a 28 nm technology at a frequency of 28 GHz, which is for example a typical frequency for 5G mobile communications applications. The quality factors used for the inductors in the simulation were set to 12, which is a typical number achievable at these frequencies. Both simulated circuits were tuned to have the same input matching.

According to the simulation results, the same input matching may be obtained, but in Fig. 5 no additional inductor for input matching needs to be provided. Noise was improved compared to the conventional approach, and there was also an improvement in the gain attributed to a bulk connection of transistor 52. Furthermore, effective losses were decreased to some extent through the use of two separate inductors with the same Q constants instead of inductor for source degeneration.

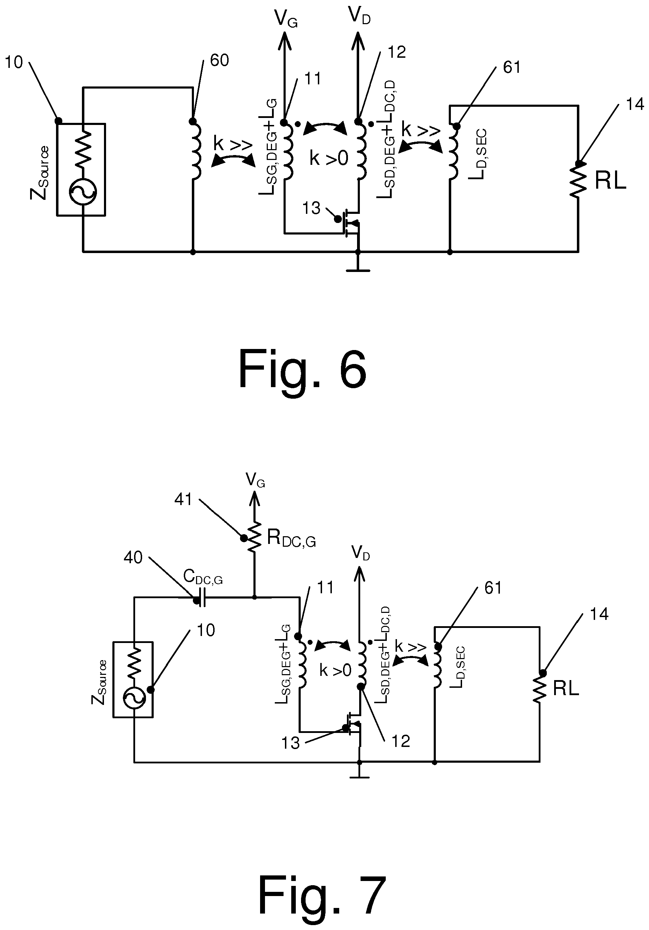

Instead of using capacitors like capacitors 40 and 41 of Fig. 4 for DC decoupling, in other embodiments transformers may be used. Example transistor circuits according to such embodiments are shown in Figs. 6 to 8. In Fig. 6, both capacitors 40, 43 are replaced by transformers. In particular, as in Fig. 1 gate inductor 11 coupled to the gate terminal of transistor 13 and drain inductor 12 coupled to the drain terminal of transistor 13 are provided to obtain a source degeneration effect. Inductor 11 is biased by DC voltage V_{G}, and inductor 12 is biased by DC voltage V_{D}.

An inductor 60 forms an input coupling transformer together with gate inductor 11 to provide DC decoupling. The coupling constant between inductors 60 and 11 may be designed to be higher than the coupling constant k between inductors 11, 12. For example, the coupling constant between inductors 60 and 11 may approximate 1, e.g. be between 0.6 and 0.9. In other embodiments, other values may be used. Inductor 60 is coupled to voltage source 10 as shown. Through the inductive coupling between inductors 60 and 11, the (AC) voltage generated by voltage source 10 is coupled to the gate terminal of transistor 13.

Furthermore, instead of capacitor 43, an inductor 61 is provided coupled inductively with drain inductor 12 to form a transformer to provide DC decoupling. The coupling strength between inductors 12, 61 may be higher than the coupling strength between inductors 11, 12. For example, the coupling strength between inductor 60 and 11 and/or the coupling strength between inductor 12 and inductor 61 may be close to 1. Inductor 61 is coupled to load 14. Through inductors 12, 61 an AC signal component of the drain current is coupled to load 14. The combination of inductors 60, 11, 12 and 61 may also be referred to as "quadfilar transformer".

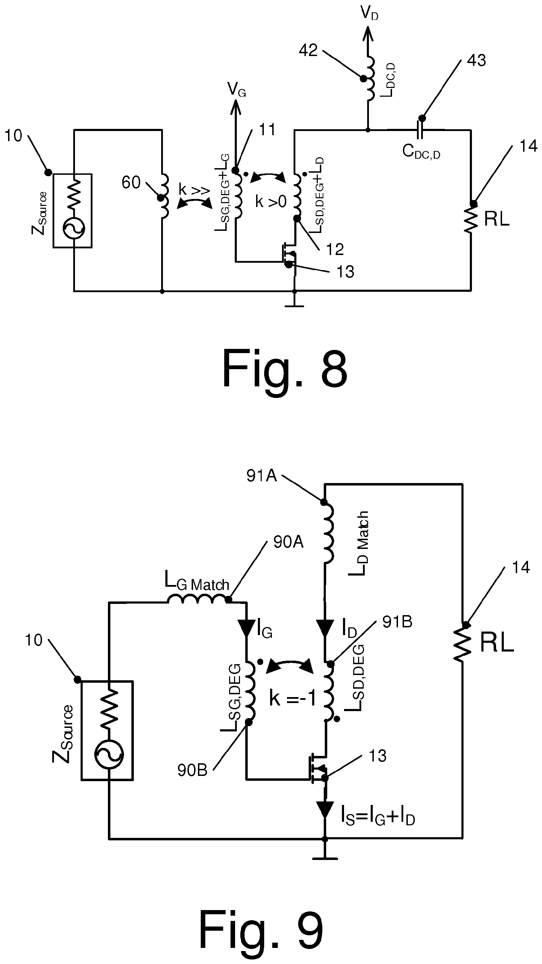

In Fig. 6, both capacitors 40, 43 of Fig. 4 have been replaced by transformers. In other embodiments now discussed with reference to Figs. 7 and 8, only one of the capacitors is replaced by a transformer.

For example, Fig. 7 shows a transistor circuit according to an embodiment where capacitor 40 of Fig. 4 together with the biasing via resistor 41 remains, while capacitor 43 has been replaced by a transformer, which, as in Fig. 6, is formed by drain inductor 12 and inductor 61.

Fig. 8 shows a case where capacitor 43 and the drain side biasing via inductor 42 is implemented as in Fig. 4, while capacitor 40 has been replaced by a transformer formed by inductor 60 and gate inductor 11, as in Fig. 6. The inductors of Figs. 7 and 8 each may be regarded as forming a trifilar transformer.

In the embodiments thus discussed so far, a positive coupling between inductors 11, 12 coupled to gate and drain terminals of transistor 13, respectively, was used to provide a source degeneration effect, which corresponds to the conventional source degeneration effect. By using two inductors coupled to gate and drain terminals instead of an inductor coupled to the source terminal as in conventional solutions, instead of a positive coupling (k>0) also a negative coupling may be introduced. This, in effect, corresponds to coupling a "negative inductance" to the source terminal of the transistor and therefore leads to a "negative" source degeneration effect. This in some implementations may be used to increase the gain or may be used to compensate an unwanted source degeneration. This "negative" source degeneration effect is also a source degeneration effect in the sense used herein. Corresponding embodiments will now be discussed referring to Figs. 9 to 12.

The embodiment of Fig. 9 essentially corresponds to the embodiment of Fig. 2, with a negative coupling. To the gate terminal of transistor 13, an inductor 90A for gate side impedance matching corresponding to inductor of 11A is coupled, and to the drain terminal of transistor 13 an inductor 91A for drain side for drain side impedance matching is coupled, corresponding to inductor 12A of Fig. 2.

Moreover, to the gate terminal a gate inductor 90B is coupled, and to the drain terminal an inductor 91B is coupled, which apart from the sign of the coupling constant correspond to inductors 11B, 12B of Fig. 2. As seen by the dots in Fig. 9, in contrast to inductors 11B, 12B inductors 90B, 91B of Fig. 9 have opposite winding directions. This leads to a coupling constant k<0, which in an ideal case may be a coupling constant k=-1.

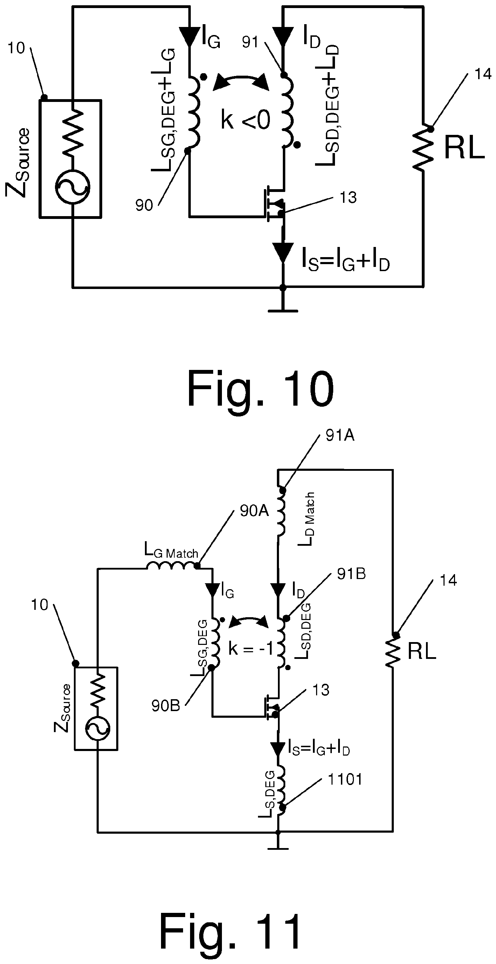

Fig. 10 shows a transistor circuit according to a further embodiment, which apart from the negative coupling corresponds to the embodiment of Fig. 1. Here, a single gate inductor 90 coupled to the gate terminal and a single drain inductor 91 coupled to the drain terminal of transistor 13 are provided, which serve both for impedance matching and for providing the - in this case negative - coupling. Again, the winding directions of inductors 90, 91 are opposite each other. The provision of two separate inductors at each of gate and drain terminals in Fig. 9 versus the provision of a single combined inductor for each of gate and drain terminals in Fig. 10 corresponds to the provision of separate inductors in Fig. 2 and the provision of single inductors in Fig. 1 for the case of a positive coupling. All explanations regarding inductances, magnitude of the coupling constants etc. made for the embodiments of Fig. 1 and 2, with the exception of the opposite winding directions and therefore opposite signs of the coupling constants, and the provision on a single chip are also applicable to the embodiments of Figs. 9 and 10. In other words, for example the absolute values of the coupling constants may be the same as explained for the embodiments of Figs. 1 and 2. Moreover, also DC biasing like explained with reference to Figs. 4, 6, 7 and 8 may be provided in the embodiments of Fig. 9 and 10.

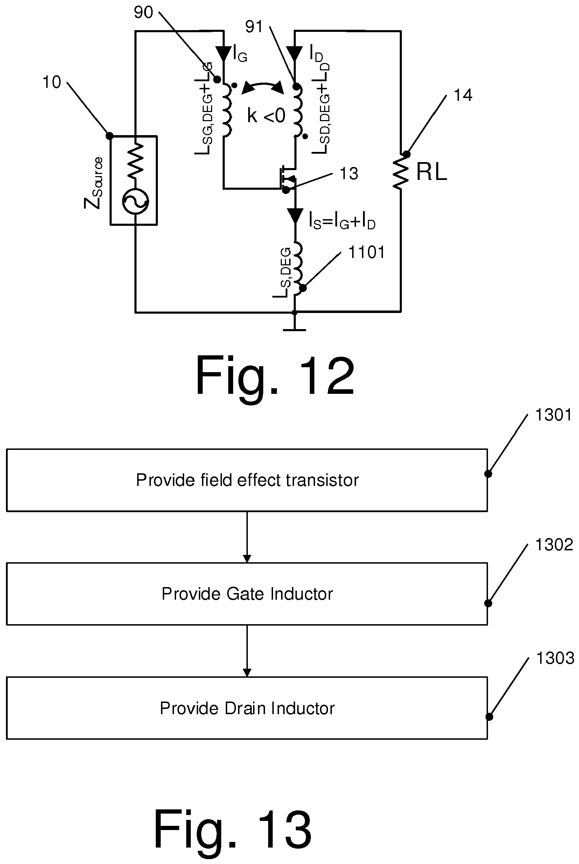

As briefly mentioned above, such a "negative" source degeneration effect may be used to compensate an unwanted source degeneration. This will be further explained referring to Figs. 11 and 12. Fig. 11 shows a transistor circuit based on the embodiment of Fig. 9, where an additional source inductor 1101 coupled to the source terminal of transistor 13 is provided. In a similar manner, a transistor circuit according to an embodiment shown in Fig. 12 is based on the transistor circuit of Fig. 10, with the additional source inductor 1101 provided. Source inductor 1101 in both cases causes conventional source degeneration. This conventional source degeneration is fully or partially counteracted by the negative source degeneration effect caused by inductors 90B, 91B of Fig. 11 or inductors 90, 91 of Fig. 12. Such an approach may be of interest in cases where an unwanted source degeneration or a too high source degeneration is present e.g. due to layout/implementation restrictions that make the provision of inductor 1101 unavoidable or highly desirable. In such cases, inductor 1101 may for example also be a parasitic inductor, which may be caused for example if a high line length of an electrical connection between the source terminal of transistor 13 and ground becomes necessary, which may lead to a correspondingly high inductance.

However, the compensation of a conventional source degeneration of Figs. 11 and 12 is only one application for using the negative source degeneration effect explained above.

Fig. 13 is a flow chart illustrating a method for manufacturing a transistor circuit according to an embodiment. The method of Fig. 13 may be used to manufacture the transistor circuits discussed with reference to Figs. 1, 2 and 4 to 12 above, but may also be used to manufacture other transistor circuits. To avoid repetitions and for ease of understanding, the method of Fig. 13 will be explained referring to the previous explanations of the transistor circuits according to various embodiments.

While the method of Fig. 13 is shown and described as a series of acts or events, the order in which these acts or events are presented is not to be construed as limiting, and the various acts or events may also be performed in different orders or also in parallel during device processing.

At 1301, the method comprises providing a field effect transistor like field effect transistor 13 of the embodiments discussed above. At 1302, the method comprises providing an gate inductor coupled to a gate terminal of the field effect transistor, for example inductor 11, 11B, 90 or 90B of the above devices. At 1303, the method comprises providing a drain inductor coupled to the drain terminal of the field effect transistor, for example one of inductors 12, 12B, 91 or 91B of the above embodiments.

The inductors provided at 1302 and 1303 are provided in proximity to each other such that they exhibit a coupling, for example with an absolute value greater than 0.1 or 0.2 (positive or negative) or any of the couplings discussed above, to provide a source degeneration effect. The various modifications illustrated in the figures and described with respect therewith may also be implemented in the method accordingly. For example, the field effect transistor at 1301 and the inductors at 1302 and 1303 may be provided on a same chip, decoupling capacitors as shown in Fig. 4 and/or transformers as shown in Figs. 6 to 8 etc. and corresponding DC biasing may be provided, etc. Therefore, it is obvious that a plurality of possible variations and modifications exist.

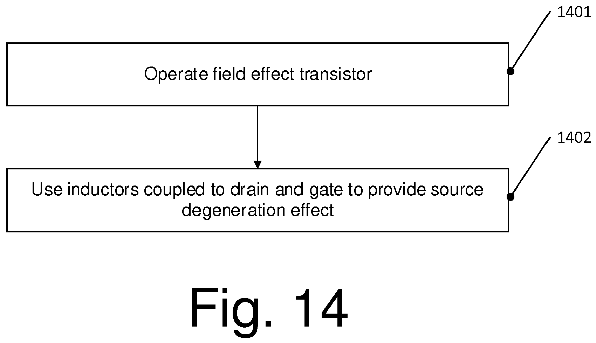

Fig. 14 is a flowchart illustrating methods according to some further embodiments.

The method of Fig. 14 may be used to operate the transistor circuits discussed with reference to Figs. 1, 2 and 4 to 12 above, but may also be used to operate other transistor circuits. To avoid repetitions and for ease of understanding, the method of Fig. 14 will be explained referring to the previous explanations of the transistor circuits according to various embodiments.

While the method of Fig. 14 is shown and described as a series of acts or events, the order in which these acts or events are presented is not to be construed as limiting, and the various acts or events may also be performed in different orders or also in parallel.

At 1401, the method comprises operating a field effect transistor, for example field effect transistor 13 of the embodiments discussed above.

At 1402, the method comprises using inductors coupled to gate and drain terminals of the field effect transistor to provide a source degeneration effect, for example as explained for inductors 11, 11B, 90 or 90B and inductors 12, 12B, 91 or 91B for the transistor circuits discussed above.

Some embodiments are defined by the following examples:
Example 1. A transistor circuit, comprising:
   a transistor,
   a first inductor coupled to the gate terminal of the transistor, and
   a second inductor coupled to the drain terminal of the transistor, wherein the first inductor and the second inductor are inductively coupled to provide a source degeneration effect for the transistor.
Example 2. The transistor circuit of example 1, wherein an absolute coupling strength between the first inductor and the second inductor is greater than 0.1.
Example 3. The transistor circuit of example 2, wherein the absolute coupling strength is greater than 0.2.
Example 4. The transistor circuit of any one of examples 1 to 3, wherein the transistor (13, 52), the first inductor and the second inductor are integrated on a same chip.
Example 5. The transistor circuit of any one of examples 1 to 4, wherein the coupling is positive.
Example 6. The transistor circuit of any one of examples 1 to 4, wherein the coupling is negative.
Example 7. The transistor circuit of example 6, further comprising a third inductor coupled to a source terminal of the transistor, wherein the negative coupling at least partially compensates a source degeneration effect by the third inductor.
Example 8. The transistor circuit of any one of examples 1 to 7, wherein the first inductor is dimensioned to provide gate side impedance matching.
Example 9. The transistor circuit of any one of examples 1 to 8, further comprising a first compensation circuitry coupled to the gate terminal and dimensioned to provide gate side impedance matching.
Example 10. The transistor circuit of any one of examples 1 to 9, wherein the second inductor is dimensioned to provide drain side impedance matching.
Examples 11. The transistor circuit of any one of examples 1 to 9, further comprising a second compensation circuitry coupled to the drain terminal and dimensioned to provide drain side impedance matching.
Example 12. The transistor circuit of any one of examples 1 to 11, further comprising a capacitor coupled to the first inductor to provide DC decoupling.
Example 13. The transistor circuit of any one of examples 1 to 11, further comprising a fourth inductor inductively coupled to the first inductor to provide DC decoupling.
Example 14. The transistor circuit of any one of examples 1 to 13, further comprising a capacitor coupled to the second inductor to provide DC decoupling.
Example 15. The transistor circuit of any one of examples 1 to 13, further comprising a fifth inductor inductively coupled to the second inductor to provide DC decoupling.
Example 16. A low noise amplifier, comprising the transistor circuit of any one of examples 1 to 15.
Example 17. A method for providing a transistor circuit, comprising:
   providing a transistor,
   providing a first inductor coupled to a gate terminal of the transistor,
   providing a second inductor coupled to the drain terminal of the transistor,
   wherein the first inductor and the second inductor are arranged to be inductively coupled to provide a source degeneration effect.
Example 18. The method of example 17, wherein the method is configured to manufacture the transistor circuit of any one of examples 1 to 15.
Example 19. A method for operating a transistor circuit, comprising:
   operating a transistor, and
   using a first inductor coupled to a gate terminal of the transistor and a second inductor coupled to a drain terminal of the transistor to provide a source degeneration effect for the transistor.
Example 20. The method of example 19, wherein the method is used to operate the transistor circuit of any one of examples 1 to 15.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A transistor circuit, comprising:
a transistor (13, 52),
a first inductor (11; 11B; 90; 90B; 50) coupled to the gate terminal of the transistor (13), and
a second inductor (12; 12B; 91; 91B; 51) coupled to the drain terminal of the transistor (13), wherein the first inductor (11; 11B; 90; 90B; 50) and the second inductor (12; 12B; 91; 91B; 51) are inductively coupled to provide a source degeneration effect for the transistor (13, 52).

2. The transistor circuit of claim 1, wherein an absolute coupling strength between the first inductor (11; 11B; 90; 90B; 50) and the second inductor (12; 12B; 91; 91B; 51) is greater than 0.1.

3. The transistor circuit of claim 1 or 2, wherein the transistor (13, 52), the first inductor (11; 11B; 90; 90B; 50) and the second inductor (12; 12B; 91; 91B; 51) are integrated on a same chip (15).

4. The transistor circuit of any one of claims 1 to 3, wherein the coupling is positive.

5. The transistor circuit of any one of claims 1 to 3, wherein the coupling is negative.

6. The transistor circuit of claim 5, further comprising a third inductor (1101) coupled to a source terminal of the transistor (13, 52), wherein the negative coupling at least partially compensates a source degeneration effect by the third inductor.

7. The transistor circuit of any one of claims 1 to 6, wherein the first inductor (11, 90) is dimensioned to provide gate side impedance matching.

8. The transistor circuit of any one of claims 1 to 7, further comprising first compensation circuitry (11A; 90A) coupled to the gate terminal and dimensioned to provide gate side impedance matching.

9. The transistor circuit of any one of claims 1 to 8, wherein the second inductor (12; 91) is dimensioned to provide drain side impedance matching.

10. The transistor circuit of any one of claims 1 to 8, further comprising a second compensation circuitry (12A; 91A) coupled to the drain terminal and dimensioned to provide drain side impedance matching.

11. The transistor circuit of any one of claims 1 to 10, further comprising one of a capacitor (40) coupled to the first inductor (11; 11B; 90; 90B; 50) to provide DC decoupling, or a fourth inductor (60) inductively coupled to the first inductor (11; 11B; 90; 90B; 50) to provide DC decoupling.

12. The transistor circuit of any one of claims 1 to 11, further comprising one of a capacitor (43) coupled to the second inductor (12; 12B; 91; 91B; 51) to provide DC decoupling, or a fifth inductor (61) inductively coupled to the second inductor (12; 12B; 91; 91B; 51) to provide DC decoupling.

13. A low noise amplifier, comprising the transistor circuit of any one of claims 1 to 12.

14. A method for operating a transistor circuit, comprising:
operating a transistor (13, 52), and
using a first inductor (11; 11B; 90; 90B; 50) coupled to a gate terminal of the transistor (13, 52) and a second inductor (12; 12B; 91; 91B; 51) coupled to a drain terminal of the transistor (13, 52) to provide a source degeneration effect for the transistor.

15. The method of claim 14, wherein the method is used to operate the transistor circuit of any one of claims 1 to 12.
